# NOUVEAU FASCICULE DE BREVET EUROPEEN

(11) **EP 0 408 456 B2**
(45) Date de publication et mention de la décision concernant l'opposition: **10.07.1996**
(45) Mention de la délivrance du brevet: 10.06.1992
(21) Numéro de dépôt: 90402011.2
(22) Date de dépôt: 12.07.1990
(51) Int. Cl.: G06K 19/06

(54) **Carte à microcircuit protégée contre l'intrusion**
Gegen Eindringen geschützte Mikroschaltungskarte
Microcircuit card protected against intrusion

(30) Priorité: 13.07.1989 FR 8909549
(43) Date de publication de la demande: 16.01.1991
(73) Titulaire: GEMPLUS CARD INTERNATIONAL, F-13420 Gemenos (FR)
(72) Inventeur: Avenier, Jean-Pierre, F-75116 Paris (FR); Lisimaque, Gilles, F-75116 Paris (FR); Maes, Philippe, F-75116 Paris (FR); Kowalski, Jacek, F-75116 Paris (FR)
(74) Mandataire: Ballot, Paul Denis Jacques

(56) Documents cités:
- EP-A- 0 178 512
- EP-A- 0 268 882
- DE-A- 3 023 427
- FR-A- 2 580 834
- GB-A- 2 195 478

## Description

L'invention se rapporte aux cartes à microcircuits, et a plus particulièrement pour objet de telles cartes protégées contre les intrusions.

Les cartes à microcircuits sont principalement utilisées comme supports pour le stockage d'informations souvent confidentielles, codes d'accès à des services notamment. Pour assurer la sécurité de fonctionnement nécessaire, il est essentiel que de telles cartes à microcircuits soient protégées des attaques des fraudeurs cherchant à violer la confidentialité attachée aux informations que ces cartes peuvent porter. les moyens d'observation qui peuvent être utilisés par des fraudeurs sont soit des moyens statiques où la carte est observée en dehors de tout moyen actif d'intrusion, soit des moyens dynamiques où la carte est observée en simulant les conditions de son fonctionnement.

Contre l'intrusion utilisant des moyens statiques, il est connu de protéger les informations stockées en les "cachant" au maximum dans le microcircuit. Par contre, il n'existe pas jusqu'à présent de moyens de protection contre une intrusion utilisant des moyens d'observation "dynamiques".

Il est aussi connu par le document FR-A-2 580 834 de disposer une résistance électrique s'étendant dans le volume du support du microcircuit. Si la résistance est coupée le microcircuit ne fonctionne plus. Il est cependant possible de falsifier l'intrusion dans le circuit en simulant extérieurement la valeur de la résistance.

Il est également connu du document EP-A-0 178 512 de réaliser sur le microcircuit des détecteurs de lumière pour empêcher une inspection optique du microcircuit.

L'invention a pour objet une carte à microcircuit protégée contre l'intrusion utilisant des moyens dynamiques.

Selon l'invention, on propose une Carte à microcircuit protégée contre l'intrusion, comprenant au moins un capteur indicateur de contrainte (C1, C2, C3) placé sur le microcircuit (10), ce microcircuit étant dans un état de précontrainte artificiel connu, cet état de précontrainte étant maintenu par une couche de protection déposée sur le microcircuit, et cet état de précontrainte étant modifié par toute tentative de prélèvement du microcircuit de la carte, le microcircuit comportant un circuit logique interne relié aux bornes du capteur pour détecter les changements de cet état de précontrainte, cette contrainte et cette précontrainte étant de type mécanique.

L'invention sera mieux comprise et d'autres caractéristiques apparaîtront à l'aide de la description qui suit, en référence aux figures annexées :
La figure 1 représente une carte à microcircuit selon l'invention, munie de trois capteurs.
Les figures 2 et 3 représentent deux exemples de capteurs utilisables ;
La figure 4 illustre le circuit associé aux capteurs pour la détection d'intrusion.

L'invention utilise le fait que, pour une intrusion utlisant des moyens dynamiques, le fraudeur doit nécessairement dégager le composant électronique du micromodule, ou de la carte, qui le supporte, afin de le mettre sous l'appareil d'observation. Or, habituellement, lorsque le composant électronique est inséré dans la carte, ou dans le micromodule lui même ensuite inséré dans la carte, la face "active" du composant, côté implantation ou diffusion, est encore apparente. Après avoir été fixé au micromodule, le composant est donc recouvert d'une couche de protection visant à le protéger contre toute agression mécanique. Lors d'une tentative d'intrusion, cette couche de protection est nécessairement endommagée par le fraudeur qui veut atteindre le microcircuit. En conséquence la carte à microcircuit selon l'invention est telle qu'un élément de détection du dommage affectant la couche de protection est inséré dans la carte, de sorte que la carte est en mesure, suite à une tentative d'intrusion, de décider de ne pas fonctionner et/ou de signaler au poste de service avec lequel elle doit coopérer qu'une intrusion a été effectuée sur cette carte.

Pour celà, d'une part un capteur permettant de détecter une contrainte mécanique dans le microcircuit est inséré dans la carte, et d'autre part en même temps que le microcircuit est recouvert de sa couche de protection, une contrainte est appliquée au microcircuit et maintenue tant que dure l'opération de séchage, la contrainte subsistant alors après séchage. Cette précontrainte peut être obtenue de préférence naturellement. Dans ce but la couche de protection est appliquée sous forme d'une goutte chaude refroidie très rapidement Au cours de ce refroidissement la résine durcie de cette goutte exerce la précontrainte. Dans un autre procédé le circuit intégré est également porté à haute température. Lors du refroidissement de la goutte et du circuit, des dilatations différentielles induisent la précontrainte recherchée. Dès ce moment, le capteur indicateur de contrainte, accessible par la logique interne du microcircuit est dans un état mesurable par une grandeur électrique, indiquant que la couche de protection est présente. Si un fraudeur, après avoir endommagé la couche de protection pour enlever le microcircuit de la carte tente de le faire fonctionner, la mesure donnée par le capteur correspond à une absence de contrainte sur le microcircuit, et ce capteur informe le circuit logique inteme du circuit de cette absence de ; contrainte cette logique interdit alors tout fonctionnement normal.

Le capteur peut être du même type que les éléments constitutifs des jauges de contrainte ou des détecteurs de pression utilisant des effets piezo électriques. Il est connecté à un indicateur, position de mémoire RAM ou drapeau ("flag") testable dans le composant, qui change d'état suivant que le microcircuit est soumis à une contrainte mécanique ou non, et que le logiciel, ou l'automate, régissant le fonctionnement du microcircuit teste à chaque nouvelle phase d'utilisation.

Le microcircuit peut être associé à plusieurs capteurs élémentaires, chacun associé à un indicateur, la logique interne du circuit testant alors l'ensemble des indicateurs associés aux capteurs. Il est alors possible, lors de la fabrication de la carte, de placer sous contrainte seulement certains des capteurs, les autres étant laissés libres de toute contrainte afin de rendre plus difficile une éventuelle reproduction des états de contrainte.

De plus, pour certains microcircuits auto-adaptables ayant une mémoire sauvegardée (EEPROM, EPROM, ou RAM sauvegardée), il est possible d'enregistrer en mémoire les valeurs de tous les indicateurs portés par le composant juste après fabrication, afin de garder ces valeurs comme valeurs de référence utilisées, ultérieurement par le circuit logique inteme. Ainsi, il est possible d'obtenir et d'utiliser des valeurs de référence différentes associées à des états de contrainte différents d'un composant à l'autre, sans modifier le cyde de fabrication des composants.

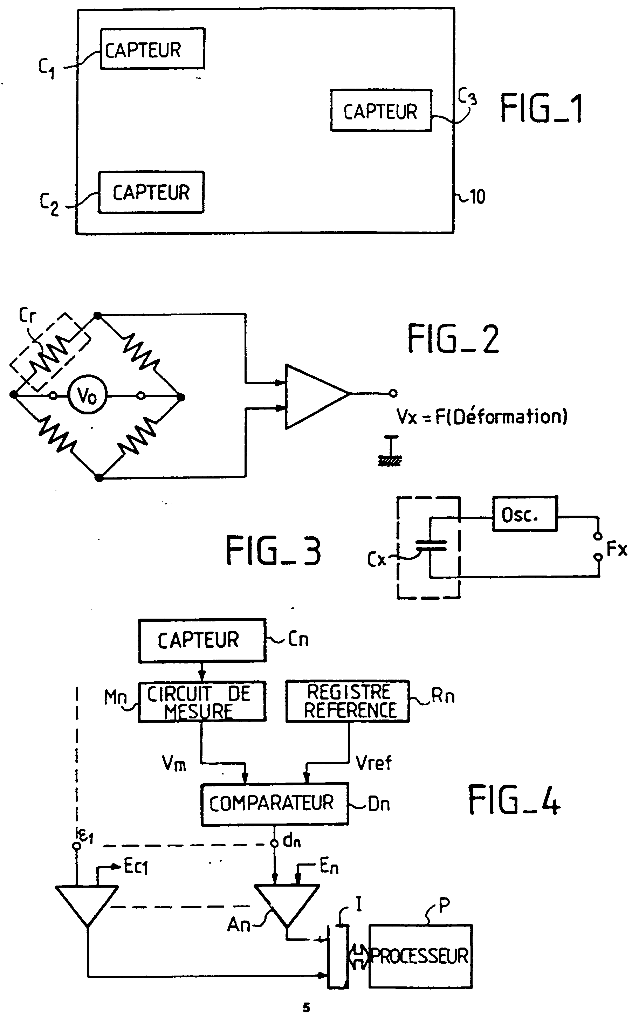

La figure 1 illustre un exemple d'implantation de trois capteurs C1, C2 et C3 sur un microcircuit 10, les sorties de ces capteurs étant directement reliées à la logique interne, non visible, du microcircuit. Cet ensemble est ensuite recouvert de la couche de protection.

La figure 2 représente le schéma équivalent d'un premier exemple de capteur indicateur de contrainte résistif Cr inséré dans un pont de mesure, du type pont de wheatstone, où la tension de sortie Vx est une fonction F de la déformation lorsqu'une tension de référence Vo est appliquée entre les entrées.

La figure 3 représente le schéma équivalent d'un deuxième exemple de capteur indicateur de contrainte, du type capacitif: la valeur de la capacité Cx varie avec la contrainte appliquée et la fréquence du signal de sortie Fx, directement liée à la capacité Cx du capteur varie avec la déformation.

La figure 4 illustre un exemple de circuit logique, inteme au microcircuit, associé à un ensemble de capteurs prévus sur ce microcircuit: chaque capteur tel que Ch est relié à un circuit de mesure Mr qui fournit une valeur mesurée Vm (tension ou fréquence par exemple) fonction de la déformation. Un registre de référence associé Rn comporte la valeur initiale en présence de déformation, mise en mémoire lors de la fabrication du circuit Ces deux valeurs sont transmises à un comparateur Dn qui fournit leur différence dn à un amplificateur à seuil An recevant par ailleurs la valeur maximale tolérée pour l'écart sur ce capteur En.

Lorsque dn dépasse En, l'amplificateur commande un changement d'état de l'étage correspondant d'un registre d'indicateurs I testé par le processeur interne P du microcircuit lors de chaque utilisation du circuit.

L'invention n'est pas limitée au mode de réalisation décrit ni aux exemples de capteurs représentés. En particulier, un seul capteur peut être prévu sur le microcircuit, ou ou contraire les capteurs peuvent être plus nombreux et arrangés sur le circuit selon une configuration différente de celle représentée. De plus pour la transformation des déformations en grandeurs électriques les capteurs peuvent générer des variations de capacité, de fréquence, ou de résistance.

## Revendications

1. Carte à microcircuit protégée contre l'intrusion, comprenant au moins un capteur indicateur de contrainte (C1, C2, C3) placé sur le microcircuit (10), ce microcircuit étant dans un état de précontrainte artificiel connu, cet état de précontrainte étant maintenu par une couche de protection déposée sur le microcircuit, et cet état de précontrainte étant modifié par toute tentative de prélèvement du microcircuit de la carte, le microcircuit comportant un circuit logique interne relié aux bornes du capteur pour détecter les changements de cet état de précontrainte, cette contrainte et cette précontrainte étant de type mécanique.

2. Carte selon la revendication 1, caractérisée en ce que plusieurs capteurs sont répartis sur la surface du microcircuit.

3. Carte selon l'une des revendications 1 et 2, caractérisée en ce que le capteur est un élément détecteur de pression de type piezo électrique.

4. Carte selon l'une des revendications 1 et 2, caractérisée en ce que le capteur comporte un élément sensible aux déformations de type résistif (Rx) et est associé à un circuit de mesure de résistance.

5. Carte selon l'une des revendications 1 et 2, caractérisée en ce que le capteur comporte un élément sensible aux déformations de type capacitif (Cx) associé à un circuit de mesure de fréquence.

6. Carte selon l'une des revendications 1 à 4, caractérisée en ce que le circuit logique interne comporte un registre d'indicateurs (I) comportant autant d'étages que de capteurs sur le microcircuit, ce registre étant relié au processeur du microcircuit qui en commande le test avant chaque utilisation.

7. Carte selon la revendication 5, caractérisée en ce que le circuit logique interne comporte, entre la sortie d'un circuit de mesure (Mn) associé à un capteur (Cn) et l'étage correspondant au registre (I) , un comparateur (Dn) relié par ailleurs à un registre de référence (Rn) et dont la sortie est couplée à un amplificateur (An) pour commander un changement d'état lorsque l'écart (dn) à la sortie du comparateur est supérieur à un écart toléré (En).

## Patentansprüche

1. Gegen Eindringen geschützte Mlkroschaltungskarte mit mindestens einem eine Zwangswirkung anzeigenden Sensor (C1, C2 und C3) in der Mikroschaltung, wobei diese Mikroschaltung (10) sich in einem bekannten künstlichen Vorzwangszustand befindet, der durch eine an der Mikroschaltung angeordnete Schutzschicht aufrecht erhalten wird, wobei dieser Vorzwangszustand durch jede versuchte Untersuchung der Mikroschaltung modifiziert wird und wobei die Mikroschaltung eine interne Logikschaltung umfaßt, die mit den Anschlüssen des Sensors verbunden ist, um Änderungen des Vorzwangszustandes zu erfassen, wobei dieser Zwangszustand und der Vorzwangszustand mechanischer Art sind.

2. Karte nach Anspruch 2, **dadurch gekennzeichnet**, daß mehrere Sensoren auf der Oberfläche der Mikroschaltung verteilt sind.

3. Karte nach einem der Ansprüche 1 und 2, **dadurch gekennzeichnet**, daß der Sensor ein Druckerfassungselement piezoelektrischer Bauart ist.

4. Karte nach einem der Ansprüche 1 und 2, **dadurch gekennzeichnet**, daß der Sensor einen auf Verformungen ansprechender Widerstand (Rx) umfaßt und einer Widerstandsmeßschaltung zugeordnet ist.

5. Karte nach einem der Ansprüche 1 und 2, **dadurch gekennzeichnet**, daß der Sensor ein Verformungen ansprechendes Element kapazitiver Bauart (Cx) umfaßt und einer Freqenzmeßschaltung zugeordnet ist.

6. Karte nach einem der Ansprüche 1 bis 4, **dadurch gekennzeichnet**, daß die interne Logikschaltung ein Anzeigeregister (I) umfaßt mit einer der Zahl der Sensoren der Mikroschaltung entsprechenden Anzahl von Stufen, wobei dieses Register mit dem Prozessor der vor jeder Benutzung das Testen desselben anfordernden Mikroschaltung verbunden wird.

7. Karte nach Anspruch 5, **dadurch gekennzeichnet**, daß die interne Logikschaltung eine Vergleichseinrichtung zwischen dem Ausgang einer einem Sensor (Cn) zugeordneten Meßschaltung (Mn) und der dem Register (I) entsprechenden Stufe der internen Logikschaltung umfaßt, die im übrigen mit einem Referenzregister (I) verbunden ist, und dessen Ausgang mit einem Verstärker (An) verbunden ist, um eine Zustandsänderung herbeizuführen, wenn die Abweichung (dn) am Ausgang der Vergle chseinrichtung eine zugelassene Abweichung (En) übersteigt.

## Claims

1. Microcircuit board protected against intrustion, comprising at least one stress indicating sensor (C1, C2, C3) placed on the microcircuit (10), this micro-circuit being in a known artificial prestressed condition, this state of prestress being maintained by a protective coating deposited over the microcircuit and the state of prestressing being modified by any attempt to remove the microcircuit from the board, with the microcircuit comprising an internal logic circuit connected to the sensor terminals so as to detect changes in the prestressed condition, the stressing and prestressing being of a mechanical type.

2. Board according to Claim 1, characterized in that several sensors are distributed over the surface of the microcircuit

3. Board according to either of Claims 1 and 2, characterised in that the sensor is a pressure detecting element of the piezo-electric type.

4. Board according to either of Claims 1 and 2, characterised in that the sensor contains a deformation-sensitive component of the resistive (Rx) type and is associated with a resistance measuring circuit.

5. Board according to either of the Claims 1 and 2, characterised in that the sensor contains a deformation-sensitive component of the capacitive (Cx) type associated with a frequency measuring circuit.

6. Board according to one of the Claims 1 to 4, characterised in that the internal logic circuit comprises an indicator register (I) containing as many stages as there are sensors on the microcircuit, this register being connected to the microcircuit's processor which controls a test before each use.

7. Board according to Claim 5, characterised in that the internal logic circuit contains, between the output from a measuring circuit (Mn) associated with a sensor (Cn) and the corresponding stage in thc register (I), a comparator (Dn) connected by another way to a reference register (Rn), the output of which is coupled to an amplifier (An) so as to control a change of state when the difference (dn) at the output of the comparator is greater than the tolerated difference (En).
